# EUROPÄISCHE PATENTANMELDUNG

(11) **EP 2 068 549 A2**
(43) Veröffentlichungstag der Anmeldung: **10.06.2009**
(21) Anmeldenummer: 08167833.6
(22) Anmeldetag: 29.10.2008
(51) Int. Cl.: H04N 1/06, H04N 1/047

(54) **Verfahren und Anordnung zur ortsbezogenen und zeitgenauen Abtastung von einem Drehkörper mit variabler Drehgeschwindigkeit**

(30) Priorität: 28.11.2007 DE 102007057339
(71) Anmelder: Siemens Aktiengesellschaft, 80333 München (DE)
(72) Erfinder: Sykosch, Ralf, 91365 Weilersbach (DE); Foltyn, Roman, 90607 Rückersdorf (DE); Haas, Markus, 9580 Drobollach (AT); Schuster, Michael, 91301 Forchheim (DE); Steinmann, Florian, 38034 Wolfenbüttel (DE)

(57) **Zusammenfassung**

Die Erfindung betrifft ein Verfahren zur ortsbezogenen und zeitgenauen Abtastung eines sich drehenden Körpers (Z) sowie eine zugehörige Anordnung. Mit einem Zeitgeber wird der Zeitstempel (t0, t1 ... tn) für mindestens einen Messpunkt (a, b, c, d) am Körper (Z) gemessen. Außerdem werden zugehörige zeitliche Bezugswerte mit dem Zeitgeber gemessen. Hieraus wird der zum Messpunkt (a, b, c, d) zugehörige Wert ausgehend von dem Zeitstempel (t0, t1, ... tn) abgeleitet.

## Beschreibung

Die Erfindung betrifft ein Verfahren zur ortsbezogenen und zeitgenauen Abtastung eines sich drehenden Körpers sowie eine zugehörige Anordnung.

Bisher wurden zur Abtastung eines sich drehenden Körpers Abtasteinheiten, z.B. Digital-Umsetzer, verwendet, die hardware-mäßig synchronisiert sind. Dabei ist die Berechnung der Abtastpunkte in Echtzeit nötig. Durch die aufwändige Berechnung der Abtastpunkte wird besonders bei hohen Drehgeschwindigkeiten eine nicht unerhebliche Verzögerung erzeugt, die den Ort der Abtastung sehr ungenau macht.

Der Erfindung liegt die Aufgabe zugrunde, ein Verfahren der oben genannten Art anzugeben, das auf einfache Weise unabhängig von der Drehgeschwindigkeit des Körpers eine Abtastung an derselben Stelle ermöglicht.

Eine weitere Aufgabe ist es, eine Anordnung zur Nutzung des Verfahrens anzugeben.

Die erste Aufgabe wird durch folgende Schritte gelöst:
a) ein Zeitstempel wird unter Anwendung eines Zeitgebers für mindestens einen Messpunkt am Körper gemessen,
b) während der Messung des Zeitstempels wird der Körper abgetastet und zu den Abtastwerten werden zugehörige zeitliche Bezugswerte unter Anwendung des Zeitgebers gemessen,
c) aus den Abtastwerten mit den zeitlichen Bezugswerten wird der zum Messpunkt gehörige Wert ausgehend von dem Zeitstempel abgeleitet.

Vorteilhafte Weiterbildungen des erfindungsgemäßen Verfahrens sind den Unteransprüchen 2 bis 8 zu entnehmen.

Die weitere Aufgabe zur Anordnung wird mit folgenden Merkmalen gelöst:
a) mit einer Messeinrichtung, die zur Messung eines Zeitstempels für mindestens einen Messpunkt am Körper dient,
b) mit mindestens einer Abtasteinrichtung, die zur Abtastung des Körpers und zur Messung von zu den Abtastwerten zugehörigen zeitlichen Bezugswerten dient, und
c) mit einem Zeitgeber, der für die Messung des Zeitstempels und der zu den Abtastwerten zugehörigen zeitlichen Bezugswerte dient.

Vorteilhafte Weiterbildungen der Anordnung sind den Unteransprüchen 10 und 11 zu entnehmen.

Im Folgenden wird ein Ausführungsbeispiel der Erfindung anhand einer Zeichnung näher erläutert. Es zeigen:
- FIG 1: eine Querschnittsdarstellung eines Zylinders mit mehreren Messpunkten,
- FIG 2: ein Diagramm mit zu verschiedenen Messpunkten zugehörigen Zeitstempeln,
- FIG 3: den Verlauf einer Messgröße, z.B. eines Farbwerts, an der Umfangsfläche des Zylinders,
- FIG 4: eine vergrößerte Darstellung von zwei Abtastwerten der Messgröße zu einem bestimmten Messpunkt, und
- FIG 5: eine Anordnung zur Nutzung des erfindungsgemäßen Verfahrens.

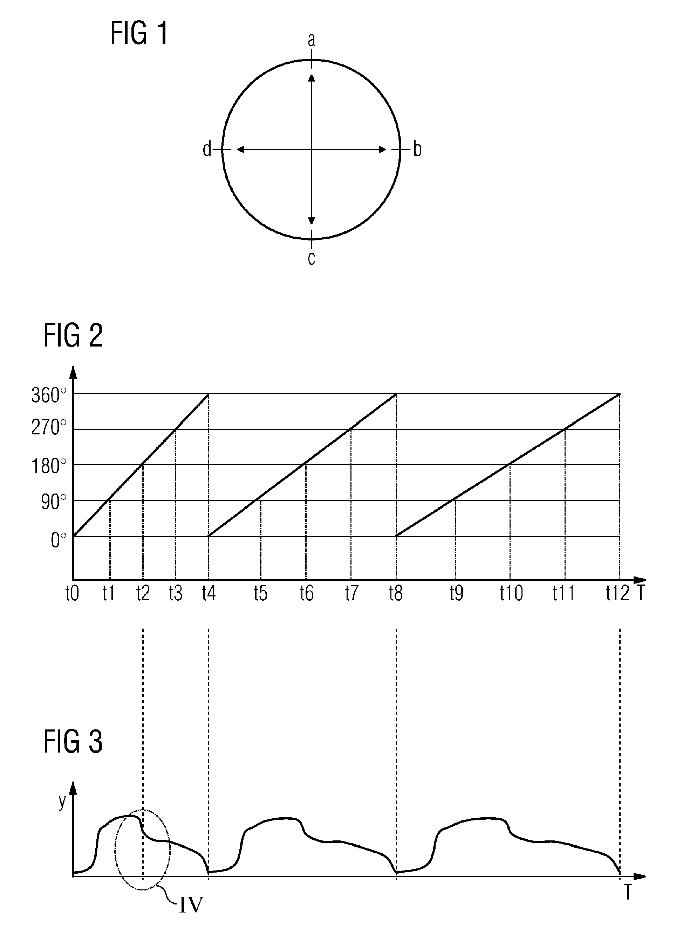

Figur 1 zeigt einen Zylinder Z im Querschnitt, der über seine Umfangsfläche z.B. einen veränderlichen Farbwert y aufweist. Anstelle des Zylinders Z kann es sich auch um einen anderen Drehkörper handeln, für den an einem oder mehreren Messpunkten der Umfangsfläche eine veränderliche Größe y bei variabler oder konstanter Drehgeschwindigkeit des sich drehenden Körpers ermittelt werden soll. Die Messpunkte können bestimmte Ortspunkte a, b, c, d gemäß Figur 1 sein, die vorteilhafterweise als Drehwinkel abgebildet werden. Im vorliegenden Ausführungsbeispiel liegen die Ortspunkte a, b, c, d jeweils um den Drehwinkel 90° vom nächsten entfernt.

Nach dem erfindungsgemäßen Verfahren werden die zu diesen Ortspunkten zugehörigen Drehwinkel mittels einer Drehwinkel-Messeinheit D gemessen. Bei Vorliegen des dem jeweiligen Ortspunkt zugehörigen Drehwinkels wird die absolute Zeit t0, t1, t2 ... tn als Zeitstempel für die verschiedenen Messpunkte gemessen, wie in Figur 2 dargestellt.

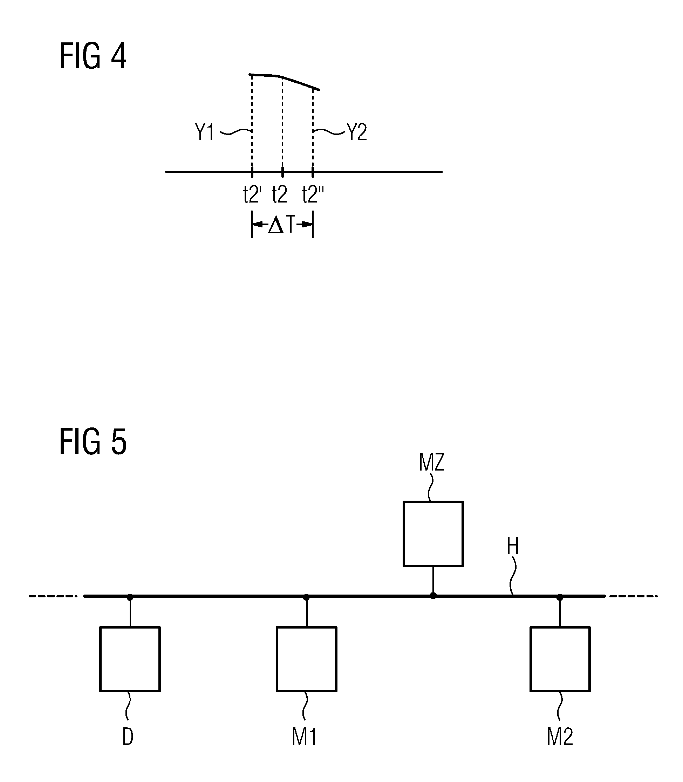

Figur 2 zeigt drei Zeitabschnitte mit unterschiedlicher Drehgeschwindigkeit des Zylinders Z während jeweils einer Volldrehung von 360°. Zeitgleich zur Drehwinkelmessung wird mittels einer Abtasteinrichtung M1 der Farbwert oder eine andere Messgröße y (siehe Figur 3) an der Umfangsfläche des Zylinders Z mit hoher Abtastrate, vorzugsweise im ns-Bereich, abgetastet. Zu den Abtastwerten Y wird die jeweils absolute Zeit gemessen, wobei für die Zeitmessung derselbe Zeitgeber wie für die oben beschriebene Messung der zu den Messpunkten zugehörigen absoluten Zeiten t0, t1, t2 ... als Zeitstempel verwendet wird. Hieraus kann für die ausgewählten Ortspunkte jeweils der Farbwert oder eine andere Messgröße y wie folgt ermittelt werden. Beispielsweise werden für den Drehwinkel 180° und der diesem zugehörigen absoluten Zeit t2 die beiden Abtastwerte Y1, Y2 zu den der Zeit t2 nächstliegenden Zeiten t2' und t2'' ermittelt (s. Figur 4).

Bei genügend hoher Abtastrate, z.B. im ns-Bereich, kann der jeweils der Zeit t2 nächstliegende Abtastwert als "richtiger" Wert gewählt werden, oder dieser wird durch Interpolation der oben genannten beiden nächstliegenden Abtastwerte gewonnen.

Die Genauigkeit bei der Ermittlung des "richtigen" Wertes lässt sich durch Einsatz mehrerer Abtasteinrichtungen M1, M2 usw. erhöhen, mit denen die Größe y abgetastet und die zu den Abtastwerten zugehörigen aktuellen Zeiten aufgenommen werden.

Der Ortspunkt, für den an der Umfangsfläche der Farbwert ermittelt werden soll, kann auch ereignisgesteuert vorgegeben werden.

Figur 5 zeigt eine Anordnung zur Nutzung des oben beschriebenen Verfahrens mit einer Drehwinkel-Messeinheit D und mit einer oder mehreren Messeinheiten M1, M2 zur Abtastung des Zylinders Z an seiner Umfangsfläche. Mit der Drehwinkel-Messeinheit D werden zu ortsbezogenen Drehwinkeln zugehörige absolute Zeiten t0, t1, ... tn als Zeitstempel mittels eines Zeitgebers gemessen. Die Drehwinkel-Messeinheit D und die Abtasteinrichtungen M1, M2 sind über einen Hochgeschwindigkeits-Bus H miteinander verbunden, über den die absolute Zeit des Zeitgebers übertragen wird, um Zeitfehler aufgrund der Übertragungsdauer zu vermeiden.

An den Hochgeschwindigkeits-Bus H ist eine Messzentrale MZ angeschlossen. Das oben beschriebene Verfahren kann mit der Anordnung gemäß Figur 5 in verschiedener Weise realisiert werden. Zum Beispiel sendet die Drehwinkel-Messeinheit D die als Zeitstempel dienenden absoluten Zeiten t0, t1 ... tn der ortsbezogenen Drehwinkel über den Hochgeschwindigkeits-Bus H an die Abtasteinrichtungen M1, M2, die aus den Abtastwerten die zu den Zeiten t0, t1 ... tn entsprechenden Werte ermitteln und diese an die Messzentrale MZ senden.

Hiervon abweichend können aber auch die Zeiten t0, t1 ... tn von der Drehwinkel-Messeinheit D nicht direkt, sondern unter Zwischenschaltung der Messzentrale MZ an die Abtasteinrichtungen M1, M2 übertragen werden.

Das Verfahren und die zugehörige Anordnung sind besonders vorteilhaft, weil die zu den Messpunkten zugehörigen "richtigen" Werte unabhängig von der Drehgeschwindigkeit mit großer Genauigkeit ermittelt werden können.

## Patentansprüche

1. Verfahren zur ortsbezogenen und zeitgenauen Abtastung eines sich drehenden Körpers (Z) mit folgenden Schritten:
a) ein Zeitstempel (t0, t1 ... tn) wird unter Anwendung eines Zeitgebers für mindestens einen Messpunkt (a, b, c, d) am Körper (Z) gemessen,
b) während der Messung des Zeitstempels (t0, t1 ... tn) wird der Körper (Z)abgetastet und zu den Abtastwerten werden zugehörige zeitliche Bezugswerte unter Anwendung des Zeitgebers gemessen,
c) aus den Abtastwerten mit den zeitlichen Bezugswerten wird der zum Messpunkt (a, b, c, d) gehörige Wert ausgehend von dem Zeitstempel (t0, t1 ... tn) abgeleitet.

2. Verfahren nach Anspruch 1,
**dadurch gekennzeichnet, dass** der Zeitgeber die absolute Zeit angibt.

3. Verfahren nach Anspruch 1 oder 2,
**dadurch gekennzeichnet, dass** der Zeitstempel (t0, t1 ... tn) sowie die zeitlichen Bezugswerte in absoluten Zeiten angegeben werden.

4. Verfahren nach einem der vorangehenden Ansprüche,
**dadurch gekennzeichnet, dass** der Messpunkt (a, b, c, d) ereignis-gesteuert vorgegeben wird.

5. Verfahren nach einem der vorangehenden Ansprüche,
**dadurch gekennzeichnet, dass** der Messpunkt als Ortspunkt (a, b, c, d) am Körper (Z) vorgegeben wird.

6. Verfahren nach einem der vorangehenden Ansprüche,
**dadurch gekennzeichnet, dass** als Messpunkt ein zum Ortspunkt (a, b, c, d) zugehöriger Drehwinkel des Körpers (Z) verwendet wird.

7. Verfahren nach einem der vorangehenden Ansprüche,
**dadurch gekennzeichnet, dass** mehrere Abtasteinrichtungen (M1, M2) den Körper (Z) abtasten.

8. Verfahren nach einem der vorangehenden Ansprüche,
**dadurch gekennzeichnet, dass** zur Messung des Zeitstempels (t0, t1 ... tn) und/oder der zu den Abtastwerten zugehörigen zeitlichen Bezugswerte die absolute Zeit des Zeitgebers über einen Hochgeschwindigkeits-Bus (H) übertragen wird.

9. Anordnung zur ortsbezogenen und zeitgenauen Abtastung eines sich drehenden Körpers (Z) mit folgenden Merkmalen:
a) mit einer Messeinrichtung (D), die zur Messung eines Zeitstempels (t0, t1 ... tn) für mindestens einen Messpunkt (a, b, c, d) am Körper dient,
b) mit mindestens einer Abtasteinrichtung (M1, M2), die zur Abtastung des Körpers (Z) und zur Messung von zu den Abtastwerten zugehörigen zeitlichen Bezugswerten dient, und
c) mit einem Zeitgeber, der für die Messung des Zeitstempels (t0, t1, ... tn) und der zu den Abtastwerten zugehörigen zeitlichen Bezugswerte dient.

10. Anordnung nach Anspruch 9,
**dadurch gekennzeichnet, dass** der Zeitgeber die absolute Zeit angibt.

11. Anordnung nach Anspruch 9 oder 10,
**dadurch gekennzeichnet, dass** für die Übertragung der absoluten Zeit des Zeitgebers zur Messung des Zeitstempels (t0, t1 ... tn) und/oder der zu den Abtastwerten zugehörigen zeitlichen Bezugswerten ein Hochgeschwindigkeits-Bus (H) vorgesehen ist, an den die Messeinrichtung (D) und die Abtasteinrichtung (M1, M2) angeschlossen ist.
